# EUROPEAN PATENT SPECIFICATION

(11) **EP 0 758 454 B1**
(45) Date of publication and mention of the grant of the patent: **15.09.1999**
(21) Application number: 95918606.5
(22) Date of filing: 25.04.1995
(51) Int. Cl.: G01R 1/073

(54) **TEST SYSTEM FOR EQUIPPED AND UNEQUIPPED PRINTED CIRCUIT BOARDS**
TESTSYSTEM FÜR BESTÜCKTE UND UNBESTÜCKTE SCHALTUNGSPLATTEN
SYSTEME D'ESSAI DESTINE A DES PLAQUETTES DE CIRCUITS IMPRIMES EQUIPEES OU NON EQUIPEES

(30) Priority: 27.04.1994 DE 4414770
(43) Date of publication of application: 19.02.1997
(73) Proprietor: MANIA GmbH & Co., 61276 Weilrod (DE)
(72) Inventor: Driller, Hubert, 61389 Schmitten (DE); Mang, Paul, 61389 Schmitten (DE)
(74) Representative: Ruschke, Hans Edvard, Dipl.-Ing.
(86) International application number: EP9501562
(87) International publication number: WO9529406

(56) References cited:
- EP-A- 0 293 497
- EP-A- 0 458 280
- EP-A- 0 468 153

## Description

The present invention relates to a device for testing substantially flat circuit carriers (printed circuit boards/ceramic substrates, etc.) which are unequipped or which are equipped with electronic components, having at least one connection device (adapter) which is necessary for adaptation to the test sample and which connects a plurality of connection points present in the device to a plurality of contact points, i.e. test points, disposed in a geometrically variable manner depending on the test sample.

In the past unequipped printed circuit boards were frequently tested with respect to their regular functioning by means of a test probe adapter for example connecting all the test points of the test sample which frequently were disposed irregularly to the regularly formed contacts of the contact point grid of the computer-controller printed circuit board test apparatus. Thus each test point was tested in a computer-controlled manner with respect to all the others in order to see whether there were too many or too few electrical connections, i.e. with respect to possible undesired interruptions or short circuits on the printed circuit board. Since the connection points of the printed circuit boards (that is the above-mentioned test points) were becoming increasingly close owing to the increasing miniaturization of the electronic components, in the past there were increasing difficulties in connecting the test or connection points of the test sample to the printed circuit board test apparatus, i.e. in adapting the test samples using increasingly complex adapters.

In the past various adaptation techniques were used for testing unequipped printed circuit boards/circuit carriers/ceramic substrates, the structure of a test probe adapter for example being a considerable factor in the total costs of the printed circuit board test procedure in particular if there was a relatively large number of test points on the test sample. In principle a special adapter always had to be manufactured for a type or series of printed circuit boards to be tested which could not therefore be used for other series of printed circuit boards. Test probe adapters of this type were distinguished in that the test probes provided therein connected the regularly disposed contact points of the test apparatus to the irregularly disposed test points of the test sample. Since by nature the test points of each series of printed circuit board to be tested were distributed differently, a particular test adapter could not be used for other test samples, as stated above. In addition a test probe adapter of this type always had to be constructed in such a way that one test probe had to be available for each individual test point, which led to considerable problems concerning space and to limits being placed on the ability to be tested of printed circuit boards using so-called universal adapters as the density of test points on the test sample increased. In addition the increasing complexity of these test probe adapters and the sometimes very high number of test probes required gave rise to considerable problems with costs in the case of small series of printed circuit boards.

In order for it still to be possible to test competitively with small series of unequipped printed circuit boards to be tested, so-called flying probe test apparatus were developed, i.e. printed circuit board test apparatus with few (usually two) test probes which were moved to and fro in a computer-controlled manner parallel to the plane of the printed circuit board to be tested in order to contact selected test points in each case (usually two points simultaneously) and investigate for undesired interruptions or short circuits. If there are numerous test points on a test sample, these flying probe testers reach their limits very rapidly if each point is to be tested with respect to the others for short circuits/interruptions since point-to-point tests of this type can take up an extraordinarily great amount of time in view of the large number. Therefore with flying probe testers of this type the tendency is towards other testing and measuring procedures which ultimately only provide a degree of probability which is high to a greater or lesser extent for regularly constructed printed circuit boards.

EP-A-0 468 153 shows a "flying probe" tester for testing substantially flat circuit carriers in which two contact needles (or more) can be moved independently of each other by controllable motor-driven devices in two directions preferably perpendicular to each other. The contact needle carriers are slideable back and forth on longitudinal supporting beams arranged above the flat circuit carrier and extending in the one direction and moveable in the other direction in order for the contact needles to reach any position on the flat circuit carrier to be tested on this testing device. Due to the fact that each of the two supporting beams can only carry one needle (or at least a few needles independently of each other), this testing device will only provide for rather slow testing of complex circuit carriers having many connector pads.

EP-A-0 293 497 discloses a device for testing substantially flat circuit carriers. This prior art as essentially acknowledged in the first part of claim 1 shows a contact probe assembly for electrically connecting a test unit to the circularly shaped connector pads of a device to be tested, which contact probe assembly comprises a motor-driven fine positioning means with movement transmission means including electric motors for transmitting the movement of a contact probe in two directions perpendicular to each other. The electro-motors are arranged above the movement transmission means such that the longitudinal axis of the contact probe extends perpendicularly to the plane defined by the two directions of movement and parallel to the motor axes and the drive shaft axes of the movement transmission means. In this testing device the contact probe assembly is moved by parallel displacement in said two directions only for the purpose of compensating for slight possible deviations of said connector pads from their intended positions on the device to be tested due to production imperfections/errors.

Neither of these documents discloses means for setting the position of the tip of each contact needle at any point of a three-dimensional portion of space. They also fail to teach a means which can be used both for testing unequipped and equipped circuit boards.

In the case of equipped printed circuit boards, i.e. finished electronic modules, so-called "in-circuit" testers are used for testing them, which testers, although they do not have to cope with the large number of test points to be tested with respect to each other as in the testing of unequipped printed circuit boards, do have to have a quite particular construction in order to be adapted to the requirements of finished electronic components of this type which leads to very high costs for the connection devices,'adapters of in-circuit testers of this type.

Viewed overall the possibility of a restricted standardization of these adapters has arisen for testing unequipped printed circuit boards using so-called universal adapters which was not however possible hitherto with the adapters for in-circuit testers. Accordingly it is the object of the present invention to provide a connection device or adapter both for unequipped and equipped printed circuit boards to be tested which can be used for both types of test sample. Therefore a connection device is to be provided for unequipped and equipped circuit boards and similar circuit carriers which adapts itself to the respective test sample and thus can really be used universally for every test sample.

A device of this type for testing substantially flat circuit carriers which are unequipped or which are equipped with electronic components comprises a contact connection device with test needles, each test needle being provided in accordance with the invention with its own motor drive, i.e. mechanical, electrical, electromagnet or pneumatic drive, for setting the position of the tip of the test needle at any point of a three-dimensional portion of space on the contact connection device ("dancing needles"). For this purpose each test needle for example can be disposed on its own platform which is constructed as a wobble plate and of which the position in space can be adjusted by a motor. The platform with the test needle projecting therefrom can also be suspended cardanically and the suspension system can be constructed such that it can be adjusted perpendicular to the plane of the platform.

Preferably the platform lies with the test needle projecting therefrom on three adjusting pins which are parallel to one another, which form the corners of a triangle and each of which *per se* is adjustable by motor in its longitudinal direction simultaneously or in succession, the platform thus constructed as a wobble plate being acted upon resiliently with respect to the adjusting pins by spring forces or the like. In this respect each adjusting pin can thus be allocated its own linear motor, or a single linear motor is provided which adjusts each of the three adjusting pins in succession. In a particularly advantageous manner the linear motors are disposed in the space between the adjusting pins and as necessary above one another in each case in order to adjust the adjusting pins. In this way each "test needle unit" consisting of test needle, associated wobble plate and motor drive disposed therebelow can be constructed with particularly small radial dimensions.

A plurality of these test needle units which can be adjusted and driven by motor is advantageously combined structurally to form a test needle module, i.e. approximately 16 test needle units of this type are combined in a module with 4 x 4 test needle units which results in 48 adjusting pins to be adjusted per module.

A fundamental embodiment of the present invention is described with reference to the attached drawings, in which:
- Figure 1: shows a test needle unit schematically; and
- Figure 2: shows schematically a rectangular contact connection panel of a printed circuit board test apparatus, not shown in further detail, consisting of 8 times 10 of these test needle units.

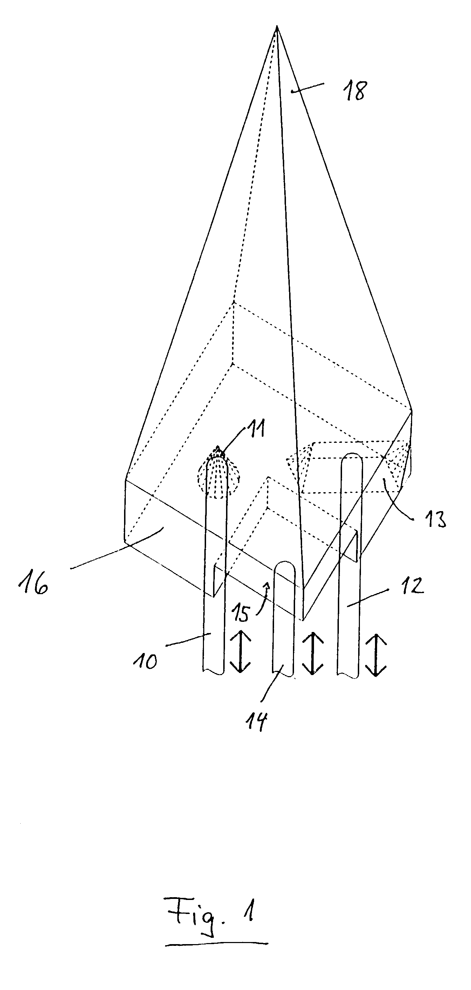

Figure 1 shows a diagram of a test needle unit having three adjusting pins 10, 12, 14 which are disposed parallel to one another at the corners of a triangle which lies in the plane of the platform 16. Associated with each adjusting pin 10, 12, 14 is a linear motor for vertically adjusting each adjusting pin in such a way that the position of the platform 16 in space is determined by the vertical position of the three adjusting pins 10, 12, 14 towards which the platform is drawn for example by a tension spring (not shown), for example by a helical spring acting centrally on the underside of the platform 16. On the top of the platform remote from the helical spring - which platform is preferably square but may have another suitable outline - a test needle 18, which is for example 80 mm long and pyramidal (or spear-like) for example, is secured in the centre perpendicular to the plate surface. Depending on the vertical position, set by motor, of the upper ends of the adjusting pins 10, 12, 14, the platform 16 and thus the tip of the test needle 18 adopt different pivot or vertical positions in space above the test needle unit, i.e. the tip of the test needle can be set at any point of a three-dimensional portion of space above and partially also laterally of the platform, the shape of this portion of space ultimately depending on the extent of the vertical adjustability of the three adjusting pins 10, 12, 14 and the geometric dimensions of the platform and the length of the test needle 18 which is if possible invariable

The use of three adjusting pins is particularly preferred since the position of a plane in space (i.e. the platform 16) is clearly defined by three points (the upper end faces of the adjusting pins on which the platform rests). On the other hand it is also conceivable for the platform or needle itself to be suspended cardanically and adjusted by motor and furthermore the length of the test needle to be designed such that it is adjustable, as a result of which a three-dimensional area above and partially laterally of the platform is then likewise attainable for the test needle tip.

It is readily possible also to embody the concept of test needles 18 which can be moved by motor in their longitudinal direction and pivoted in any direction transversely thereto in some other way for example by means of a conventional sliding guide for each test needle unit, which sliding guide extends vertical to the horizontal initial position of the platform 16 in order to adjust the vertical position of the platform on which the test needle 18 is then mounted so as to rotate about an axis extending vertical to the platform and to pivot about an axis extending parallel thereto. A three-dimensional portion of space above and partially laterally of the test needle platform can also be reached by the tip of the test needle unit by virtue of a test needle drive of this type.

In the currently preferred embodiment of a test needle unit of this type the three adjusting pins 10, 12, 14 are guided parallel to one another in suitable linear guides (e.g. plastics material slide bearings) in a plurality of guide plates which are at a vertical spacing from one another and are parallel to one another, one adjusting pin 10 engaging with its upper rounded end in a conical recess 11 in the underside of the platform whereby the platform is secured on the pin 10 transversely thereto but can nevertheless pivot in all directions about this recess 11.

As Figure 1 shows the point of contact of the three adjusting pins 10, 12, 14 lie on the platform 16 at the corners of a triangle the next point of contact of the adjusting pin 12 in the clockwise direction starting from the conical recess 11 being a wedge-shaped elongate recess 13 which is aligned relative to the recess 11; since the distance on the platform from the point of contact of the adjusting pin 10 to the point of contact of the adjusting pin 12 varies depending on the pivot position of the platform 16 in the form of a wobble plate, the lengths have to be compensated via the longitudinal extension of the wedge-shaped recess 13 in the underside of the platform 16, i. e. the point of contact of the adjusting pin 12 drifts depending on the pivot position of the platform 16 in view of the inability of 10 and 12 in Figure 1 to move radially to the lefthand side or righthand side. The third adjusting pin 14 is supported on the underside of the platform 16 on an offset intermediate plane 15 and the point of contact of 14 drifts - depending on the pivot position or position of the platform 16 - in space on a curved, self-contained path on the intermediate plane. Owing to the vertical position of the intermediate plane 15 the adjusting pins 10, 12, 14 act at approximately the same vertical level in the vicinity of the platform 16.

The platform 16 is acted upon in the direction of the upper ends of the adjusting pins 10, 12, 14 by a tension spring (not shown in greater detail) or the like which acts on the underside of the platform approximately centrally thereon in order thus to attain a precisely defined position of the platform in space according to the vertical position of the adjusting pins.

Disposed on the top of the platform is a test needle 18 which extends perpendicular thereto and which, as Figure 1 shows, can be pyramidal or actually needle-shaped for example. Owing to the above-mentioned particular adjustability of the platform 16 in various pivot and vertical positions as a result of the adjusting pins 10, 12, 14, the test needle 18 can be set at any point of a three-dimensional area which lies vertically above and partially also laterally of the platform 16 or of the entire test needle unit in order thus to contact a test point in any position in the above-mentioned three-dimensional portion of space with the tip of the test needle.

In the present context there is no need to consider the type of electrical connection of the test needle to the test circuit of the conventional computer-controlled printed circuit board test apparatus, not shown in the drawing, or of an "in-circuit" tester. It is familiar to the person skilled in the art of test apparatus for equipped or unequipped printed circuit boards and is furthermore only of minor importance in the present context.

Each of the three adjusting pins 10, 12, 14 of a test needle unit is set vertically for example by means of an associated linear motor in each case, i.e. a total of three motors which are disposed above one another in the area below the platform 16 in each case and between the three adjusting pins, i.e. the adjusting pins run past the motors externally and the respective motor is associated with the associated adjusting pin by means of suitable force-transmission mechanisms. However it is also possible to provide only one common (linear) motor for all three adjusting pins which motor then adjusts the three adjusting pins in succession by means of suitable coupling mechanisms in order to attain the desired position of the platform 16 in space and thus the necessary position of the test needle 18.

In a preferred embodiment of a test apparatus for equipped or unequipped printed circuit boards, 16 test needle units of this type for example with square platforms (rectangular, triangular, hexagonal or other outlines of the platform are also possible) and test needles disposed thereon are combined to form "modules" which have a total of 16 test needle units of this type and which are in each case disposed in fours in the transverse and longitudinal directions. As a result thereof each module requires a total of 48 adjusting pins to be controlled/set which occurs via a computer associated with the module.

Overall a typical tester provided with the connection device (adapter) according to the invention has 1500 of these test needles for example for each side of a test sample, i.e. in the case of a double-sided tester 2 x 1500 needles. If the test sample in this example has more than 1500 test or connection points per side then the entire test procedure (i.e. the testing of each point with respect to all the others) can be divided into a plurality of partial measurements (test cycles) in which different subsets of test points on the test sample are connected to contact points of the connection device in order thus to adapt the higher connection density of the connection device, i.e. to the number of test needles (see Claim 2). The number of measuring possibilities does not increase linearly but quadratically with the number of test needles when it is a matter of point-to-point testing for short circuits/interruptions.

Depending on its complexity, the assembly of a conventional test probe adapter lasts for approximately 1 to 4 hours or more. On the other hand a connection device/adapter according to the present invention enables 50 test samples for example to be tested per hour without an adapter having to be constructed since each of the test needles can be set by motor at the position of the connection points to be tested on the printed circuit board by a suitable computer-control system. Therefore the limit of use for (test probe) adapters alters approximately to the batch size range of approximately 250 boards, i.e. with less than 250 printed circuit boards to be tested the expenditure on producing an adapter is greater than the computing time or testing time on a printed circuit board test apparatus.

Since each test needle can be set individually by motor, namely in steps of a few micrometres, an in-circuit tester which only requires far fewer connection points for printed circuit boards equipped with electronic components can also be connected to this connection device according to the invention. In principle the connection device according to the invention can be regarded as a "universally adjustable interface" for the most widely varying types of electronic components.

For the successful testing of printed circuit boards or for the proper connection of a test apparatus to a test sample it is indispensable for it to be possible for two test points which are situated very close to one another to be reached by the test needles, i.e. each test needle unit must be able to reach into the partial area, on a test sample, associated with an immediately adjacent test needle unit by a distance which is large to a greater or lesser extent. Each test needle unit must therefore be able to reach not only the partial area of a cellular surface division pattern (e.g. triangular, rectangular, hexagonal or the like) associated with the unit itself but also a sufficiently large partial area of the cellular surface division areas associated with the adjacent test needles.

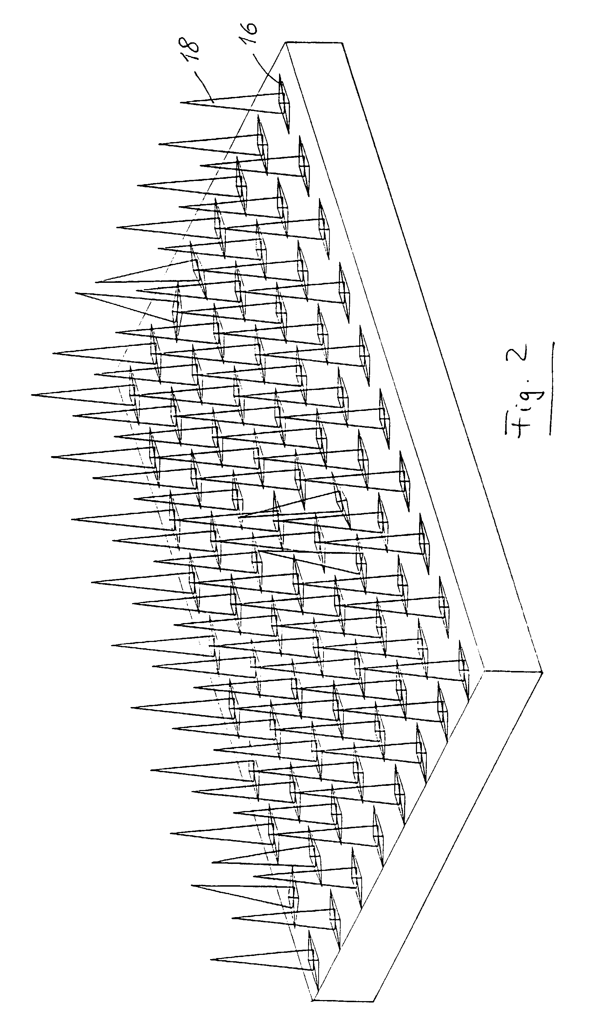

In conjunction with the structure of a connection device (as shown in Figure 2) consisting of a plurality of test needle units of this type (Figure 1) it is readily possible to replace one or more test needle units by so-called special function modules, i.e. assemblies which assume tasks or functions other than the pure contacting of test points, i.e. a print module which marks a test sample recognized as being faulty by printing or stamping on corresponding information or a securing module which is equipped for example with rigid pilot pins in order to secure the respective test sample in the measuring position in which it is contacted by the test needle units. The special function modules can also assume other tasks such as the mechanical delivery and removal of test samples or the optical measurement of the test sample in the test station.

## Claims

1. Device for testing substantially flat circuit carriers which are unequipped or which are equipped with electronic components, including at least one connection device which is necessary for adaptation to the test sample and which connects a plurality of connection points present in the device to a plurality of contact points which vary geometrically according to the test sample, characterized in that the connection device is partially or totally divided into a cellular surface division pattern in which each cell is provided with a contact needle (18) which can be moved by controllable motor driven devices (10, 12, 14) for setting the position of the tip of each contact needle at any point of a three-dimensional portion of space such that they can reach any point of a partial area of a test sample surface on one side of the test sample in each case.

2. Device according to Claim 1, characterized in that the entire test procedure is divided into a plurality of partial measurements in which different subsets of contact points on the test sample are connected to contact points of the connection device in order to adapt possible higher connection densities of the test sample to the connection density of the connction device.

3. Device according to Claim 1 or 2, characterized in that the connection device(s) is (are) divided into function modules which substantially do not overlap each other and which can therefore be aligned and with which one or more surface division patterns are associated in each case.

4. Device according to Claim 3, characterized in that at least one function module is provided with special mechanical functions and occupies the place of one or more electronic function modules.

5. Device according to Claim 4, characterized in that at least one function module is replaced by a wildcard of which the task exclusively resides in completing the connection device geometrically in its surface division pattern or stabilizing it mechanically.

6. Device according to any one of Claims 1 to 5, characterized in that a cell base predetermined by the surface division pattern is associated with each movable contact needle; and in that the connection area on the test sample surface associated with a needle consists of its own cell base and of parts of the cell base of the geometrically adjacent test needle.

7. Device according to Claims 1 to 6, characterized in that the contact needles are supported resiliently in their longitudinal direction.

8. Device, characterized in that a connection device claimed in Claims 1 to 6 is disposed on both sides of the test sample whereby both the simultaneous contacting on both sides is rendered possible and the dissipation of force by the symmetry of the distribution of the contact means is ensured.

9. Device according to Claims 1 to 8, characterized in that the contact meedles are secured at their low ends so as to be optionally replaceable on a carrier member which determines the contact position of the needle at/on the test sample by its position or by its alignment.

10. Device according to Claim 9, characterized in that the carrier member is in the form of a vertically movable platform which can pivot to all sides.

11. Device according to Claim 9 or 10, characterized in that the carrier member is aligned by at least three substantially vertically movable supports.

12. Device according to Claim 9 or 10, characterized in that the carrier member is aligned by four supports which are disposed in a reactangle and are substantially vertically movable.

13. Device according to Claims 1 to 9, characterized in that the contact needles are positioned by a combination of lifting, rotating and pivoting movements.

## Patentansprüche

1. Vorrichtung zum Prüfen von unbestückten oder mit elektronischen Komponenten bestückten, im wesentlichen flachen Verdrahtungsträgern, mit mindestens einer zur Anpassung an den Prüfling erforderlichen Anschlußvorrichtung, welche eine Pluralität von in der Vorrichtung vorhandenen Anschlußstellen mit einer Pluralität von je nach Prüfling geometrisch variablen Kontaktstellen verbindet, dadurch gekennzeichnet, daß die Anschlußvorrichtung teilweise oder vollständig aufgeteilt ist in ein zellenförmiges Flächenaufteilungsmuster, in dem jede Zelle mit einer Kontaktnadel (18) versehen ist, die durch gesteuerte motorgetriebene Vorrichtungen (10, 12, 14) steuerbar ist, um die Position der Spitze einer jeden Kontaktnadel auf einen beliebigen Punkt eines drei-dimensionalen Abschnittes des Raumes einzustellen derart, daß sie jeden Punkt eines Teilbereiches einer Prüflings-Oberfläche auf einer Seite des Prüflings in jedem Fall erreichen können.

2. Vorrichtung nach Anspruch 1, dadurch gekennzeichnet, daß der gesamte Testvorgang in mehrere Teilmessungen aufgeteilt ist, bei denen unterschiedliche Teilmengen von Kontaktstellen auf dem Prüfling mit Kontaktstellen der Anschlußvorrichtung verbunden sind, um eventuell vorhandene höhere Anschlußdichten des Prüflings an die Anschlußdichte der Anschlußvorrichtung anzupassen.

3. Vorrichtung nach Anspruch 1 oder 2, dadurch gekennzeichnet, daß die Anschlußvorrichtung(en) in sich gegenseitig im wesentlichen nicht überdeckende und damit anreihbare Funktionsmodule aufgeteilt ist (sind), denen jeweils ein oder mehrere Flächenaufteilungsmuster zugeordnet sind.

4. Vorrichtung nach Anspruch 3, dadurch gekennzeichnet, daß wenigstens ein Funktionsmodul mit speziellen mechanischen Funktionen versehen ist und den Platz von einem oder mehreren elektronischen Funktionsmodulen einnimmt.

5. Vorrichtung nach Anspruch 4, dadurch gekennzeichnet, daß wenigstens ein Funktionsmodul ersetzt wird durch einen Platzhalter, dessen Aufgabe ausschließlich darin besteht, die Anschlußvorrichtung in ihrem Flächenaufteilungsmuster zu vervollständigen oder mechanisch zu stabilisieren.

6. Vorrichtung nach einem der Ansprüche 1 bis 5, dadurch gekennzeichnet, daß jeder beweglichen Kontaktnadel eine von dem Flächenaufteilungsmuster vorbestimmte Zellengrundfläche zugeordnet ist; und daß der einer Nadel zugeordnete Anschlußbereich auf der Prüflingsoberfläche aus der eigenen Zellengrundfläche und aus Teilen der Zellengrundfläche der geometrisch benachbarten Prüfnadel besteht.

7. Vorrichtung nach Anspruch 1 bis 6, dadurch gekennzeichnet, daß die Kontaktnadeln in ihrer Längsrichtung federnd abgestützt sind.

8. Vorrichtung, dadurch gekennzeichnet, daß eine Anschlußvorrichtung gemäß den Ansprüchen 1 bis 6 auf beiden Seiten des Prüflings angeordnet ist, wodurch eine gleichzeitige Kontaktierung auf beiden Seiten möglich gemacht wird und eine Kraftableitung durch die Symmetrie der Verteilung der Kontaktmittel gewährleistet ist.

9. Vorrichtung nach den Ansprüchen 1 bis 8, dadurch gekennzeichnet, daß die Kontaktnadeln an ihrem Fußpunkt optional austauschbar auf einem Trägerkörper befestigt sind, welcher durch seine Lage bzw durch seine Ausrichtung die Kontaktstelle der Nadel an/auf dem Prüfling bestimmt.

10. Vorrichtung nach Anspruch 9, dadurch gekennzeichnet, daß der Trägerkörper als vertikal bewegliche und allseitig schwenkbare Plattform ausgebildet ist.

11. Vorrichtung nach Anspruch 9 oder 10, dadurch gekennzeichnet, daß die Ausrichtung des Trägerkörpers durch mindestens drei im wesentlichen vertikal bewegliche Stützen erfolgt.

12. Vorrichtung nach Anspruch 9 oder 10, , dadurch gekennzeichnet, daß die Ausrichtung des Trägerkörpers durch vier im Rechteck angeordnete und im wesentlichen vertikal bewegliche Stützen erfolgt.

13. Vorrichtung nach Anspruch 1 bis 9, dadurch gekennzeichnet, daß die Positionierung der Kontaktnadeln durch eine Kombination aus Hub-, Dreh- und Schwenkbewegung ausgeführt wird.

## Revendications

1. Appareil de tests de supports pratiquement plats de circuits qui ne sont pas équipés ou qui sont équipés de composants électroniques, comprenant au moins un dispositif de connexion qui est nécessaire à l'adaptation à l'échantillon testé et qui connecte plusieurs points de connexion présents dans l'appareil à plusieurs points de contact qui varient géométriquement suivant l'échantillon testé, caractérisé en ce que le dispositif de connexion est divisé partiellement ou totalement en un dessin de répartition cellulaire de la surface dans lequel chaque cellule a une aiguille de contact (18) qui peut être déplacée par des dispositifs (10, 12, 14) entraînés par des moteurs qui peuvent être commandés pour le réglage de la position du bout de chaque aiguille de contact en un point quelconque d'une partie tridimensionnelle de l'espace de manière qu'elle puisse atteindre un point quelconque d'une zone partielle d'une surface de l'échantillon testé d'un côté de l'échantillon testé dans chaque cas.

2. Appareil selon la revendication 1, caractérisé en ce que l'ensemble de la procédure de test est divisé en plusieurs mesures partielles dans lesquelles des sous-ensembles différents de points de contact de l'échantillon testé sont connectés aux points de contact du dispositif de connexion pour l'adaptation de plus grandes densités possibles de connexion de l'échantillon de test à la densité de connexion de l'appareil de connexion.

3. Appareil selon la revendication 1 ou 2, caractérisé en ce que le dispositif ou les dispositifs de connexion sont divisés en modules de fonction qui ne se recouvrent pratiquement pas et qui peuvent donc être alignés et avec lesquels un ou plusieurs motifs de répartition de la surface sont associés dans chaque cas.

4. Appareil selon la revendication 3, caractérisé en ce qu'un module de fonction au moins a des fonctions mécaniques spéciales et occupe l'emplacement d'un ou plusieurs modules de fonction électronique.

5. Appareil selon la revendication 4, caractérisé en ce qu'un module de fonction au moins est remplacé par un module générique dont la tâche réside exclusivement dans la réalisation complète géométrique du dessin de répartition de la surface de l'appareil de connexion ou dans sa stabilisation mécanique.

6. Appareil selon l'une quelconque des revendications 1 à 5, caractérisé en ce qu'une base de cellule prédéterminée par le dessin de répartition de surface est associée à chaque aiguille mobile de contact, et en ce que la région de connexion de la surface de l'échantillon testé associée à une aiguille est constituée de sa propre base de cellule et des parties de la base de cellule de l'aiguille géométriquement adjacente de test.

7. Appareil selon les revendications 1 à 6, caractérisé en ce que les aiguilles de contact sont supportées élastiquement dans leur direction longitudinale.

8. Appareil caractérisé en ce qu'un appareil de connexion selon l'une des revendications 1 à 6 est placé des deux côtés de l'échantillon testé si bien qu'un contact simultané des deux côtés est rendu possible et la dissipation de la force est assurée par la symétrie de distribution des dispositifs de contact.

9. Appareil selon les revendications 1 à 8, caractérisé en ce que les aiguilles de contact sont fixées à leurs extrémités inférieures afin qu'elles puissent être remplacées éventuellement sur un organe de support qui détermine la position de contact de l'aiguille sur l'échantillon testé par sa position ou par son alignement.

10. Appareil selon la revendication 9, caractérisé en ce que l'organe de support est sous forme d'une plate-forme mobile verticalement qui peut pivoter de tous les côtés.

11. Appareil selon la revendication 9 ou 10, caractérisé en ce que l'organe de support est aligné par au moins trois supports mobiles en direction sensiblement verticale.

12. Appareil selon la revendication 9 ou 10, caractérisé en ce que l'organe de support est aligné par quatre supports qui sont disposés suivant un rectangle et qui sont mobiles en direction pratiquement verticale.

13. Appareil selon les revendications 1 à 9, caractérisé en ce que les aiguilles de contact sont positionnées par une combinaison de mouvements de soulèvement, de rotation et de pivotement.
